# FASCICULE DE BREVET EUROPEEN

(11) **EP 2 602 695 B1**
(45) Date de publication et mention de la délivrance du brevet: **18.03.2015**
(21) Numéro de dépôt: 12196012.4
(22) Date de dépôt: 07.12.2012
(51) Int. Cl.: G06F 3/033, G01R 27/02, G06F 3/0354, G06F 3/0362, G06F 3/038, H01C 10/30

(54) **Dispositif d'entrée de données à potentiomètre et manche destiné au pilotage d'un aéronef, le manche comprenant le dispositif d'entrée de données**
Dateneingabevorrichtung mit Potentiometer und Steuerknüppel zum Steuern eines Luftfahrzeugs, wobei der Steuerknüppel diese Dateneingabevorrichtung umfasst
Data input device with potentiometer and control stick for piloting an aircraft, the control stick including the data input device

(30) Priorité: 09.12.2011 FR 1103775
(43) Date de publication de la demande: 12.06.2013
(73) Titulaire: Thales, 92200 Neuilly Sur Seine (FR)
(72) Inventeur: Bellon, Bernard, 41360 Savigny sur Braye (FR)
(74) Mandataire: Collet, Alain

(56) Documents cités:
- EP-A1- 1 887 368
- WO-A1-92/00504
- Mark Dzidowski: "Solving Drift in Proportional (Potentiometer) Joysticks", , 7 juillet 2010 (2010-07-07), XP055033428, Extrait de l'Internet: URL:http://controldeviceseng.com/2010/07/0 7/solving-drift-in-proportional-potentiome ter-joysticks/ [extrait le 2012-07-20]

## Description

L'invention concerne un dispositif d'entrée de données mettant en oeuvre un potentiomètre. Ce type de dispositif est utilisé pour connaître la valeur d'un paramètre susceptible d'évoluer de façon continue, comme par exemple un déplacement.

On trouve par exemple ce type de dispositif dans le domaine aéronautique et plus précisément dans un manche utilisé pour le pilotage des aéronefs, avions ou hélicoptères. Le pilote manoeuvre ce manche pour modifier l'assiette de son appareil. Il est capital de connaitre avec précision la position du manche pour répercuter les ordres du pilote. Le manche est communément disposé entre les jambes du pilote et possède plusieurs degrés de libertés permettant ainsi au pilote de commander plusieurs types d'organes mobiles de son aéronef tels que par exemple les ailerons et la gouverne de profondeur. Le manche peut par exemple être mobile suivant deux rotations ou une rotation et une translation. Récemment sont apparus des manches de taille réduite appelés mini manches, bien connus dans la littérature anglo-saxonne sous le nom de « joystick » permettant toujours au pilote de commander son aéronef.

L'invention s'intéresse à la conversion en information électrique des déplacements du manche. Plus précisément, le manche possède pour chaque degré de liberté, au moins un potentiomètre permettant de convertir la position du manche en information électrique sous forme d'une tension continue. Le potentiomètre peut être rotatif pour convertir une rotation du manche ou linéaire pour convertir une translation d'un manche ou d'un mini manche.

L'invention n'est pas limitée à un manche permettant le pilotage d'un aéronef. L'invention peut être mise en oeuvre pour toute utilisation d'un potentiomètre.

Il est connu d'appliquer une tension continue entre les deux extrémités du potentiomètre et de lire la tension présente sur le curseur du potentiomètre pour obtenir l'information recherchée. Cette lecture se fait à haute impédance pour éviter les pertes de linéarité entre la position du curseur et la tension lue. Cette haute impédance entraine un courant très faible qui ne permet pas de garantir une bonne continuité des contacts. Des défauts peuvent intervenir au niveau du contact du curseur dans le potentiomètre lui-même ou au niveau de contacts extérieurs au potentiomètre par exemple dans un connecteur le reliant à son environnement. L'utilisation de contacts dorés permet d'améliorer la qualité de la connectique mais n'apporte pas de solution parfaite aux problèmes dans la continuité des contacts.

De plus, une détection de panne peut être difficile à mettre en oeuvre. Un défaut de continuité peut ne devenir apparent que lors d'un déplacement du curseur, ce qui peut être critique pour la mission d'un aéronef. Le pilote ne s'apercevrait alors d'un défaut de son manche que lorsqu'il souhaite manoeuvrer son aéronef.

Le document http://controldeviceseng.com/2010/07/07/solving-drift-in-proportional-potentiometer-joysticks/ décrit les problèmes connus des potentiomètres utilisées dans des dispositifs d'entrée de données, en particulier ceux utilisés pour contrôler des machines, ainsi que les solutions classiques pour résoudre ces problèmes.

L'invention permet de garantir un courant minimal dans le potentiomètre tout en conservant la linéarité de la mesure.

A cet effet, l'invention a pour objet un dispositif d'entrée de données comprenant un curseur et des moyens convertissant une position du curseur en une tension électrique, **caractérisé en ce qu'il** comprend en outre :
- un potentiomètre s'étendant entre deux extrémités, le potentiomètre possédant un premier et un deuxième points de connexion fixes situés respectivement à chacune des extrémités du potentiomètre, un troisième point de connexion fixe situé à une position intermédiaire du potentiomètre entre les deux extrémités et un quatrième point de connexion mobile formant le curseur et pouvant se déplacer entre les deux extrémités,
- des moyens pour alimenter le potentiomètre par le troisième point de connexion au moyen d'une première tension fixe,
- des moyens pour alimenter le potentiomètre par le curseur au moyen d'une source de courant,
- des moyens pour mesurer une différence de tension entre le premier et deuxième point de connexion, la différence de tension formant la tension électrique représentative de la position du curseur.

L'invention a également pour objet un manche destiné au pilotage d'un aéronef, le manche comprenant un dispositif d'entrée de données selon l'invention.

L'invention sera mieux comprise et d'autres avantages apparaîtront à la lecture de la description détaillée d'un mode de réalisation donné à titre d'exemple, description illustrée par le dessin joint dans lequel :
la figure 1 représente un schéma de principe d'un dispositif d'entrée de données selon l'invention ;
la figure 2 représente un exemple plus précis de dispositif reprenant le schéma de principe de la figure 1 ;
les figures 3 et 4 représentent l'évolution de tensions et de courants dans le dispositif de la figure 2.

Par souci de clarté, les mêmes éléments porteront les mêmes repères dans les différentes figures.

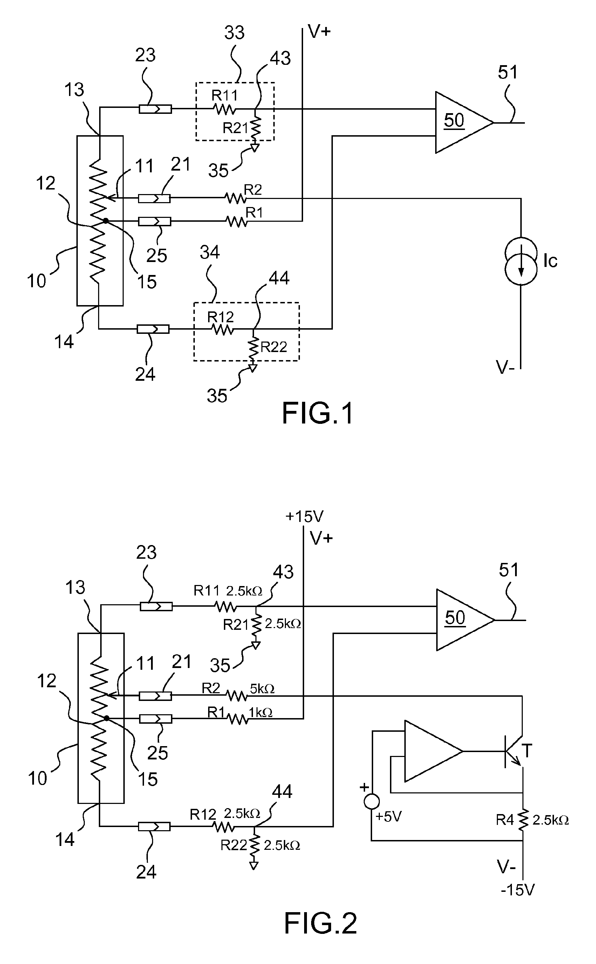

La figure 1 représente un dispositif d'entrée de données comprenant un potentiomètre 10 dont un curseur 11 peut être déplacé. Le potentiomètre 10 comprend une résistance 12 s'étendant entre deux extrémités 13 et 14. Le curseur 11 peut se déplacer le long de la résistance 12 pour assurer un contact électrique avec un point courant de la résistance 12 situé entre les deux extrémités 13 et 14.

Par exemple, dans le cas d'un manche mis en oeuvre dans le cockpit d'un aéronef, la résistance 12 est fixe par rapport au cockpit et le curseur 11 est solidaire d'une partie mobile du manche, partie mobile destinée à être manoeuvrée par un pilote de l'aéronef. Alternativement, la résistance 12 peut être mobile et le curseur 11 fixe.

La fonction principale du dispositif d'entrée de données est de convertir la position du curseur 11 en une information électrique qui est par exemple utilisée pour commander un actionneur.

Le potentiomètre 10 possède un point milieu 15. Plus précisément, il est possible d'établir un contact électrique fixe avec la résistance au milieu de celle-ci. Autrement dit, pour une valeur totale R de la résistance 12, on a une valeur R/2 entre chacune des extrémités 13 et 14 et le point milieu 15. Alternativement, l'invention peut être mise en oeuvre avec un point de connexion fixe qui peut être situé à une autre position de la résistance qu'au milieu de celle-ci. Ce point de connexion est simplement situé à une position intermédiaire entre les deux extrémités 13 et 14. Il suffit simplement que ce point intermédiaire soit distinct des deux extrémités 13 et 14.

Le dispositif peut comporter un connecteur comprenant quatre bornes de connexion 21, 23, 24 et 25 permettant chacune de raccorder un des points du potentiomètre 10, respectivement 11, 13, 14 et 15, à d'autres composants du dispositif. Il est également possible de se passer de connecteur et d'assurer un raccordement inamovible par exemple par soudage.

Le dispositif comprend des moyens pour alimenter le potentiomètre 10 par son point milieu 15 au moyen d'une première tension fixe. A cet effet, une source de tension V+ est raccordée à la borne de connexion 25, et donc au point milieu 15, par l'intermédiaire d'une résistance R1.

Le dispositif comprend des moyens pour alimenter le potentiomètre 10 par le curseur 11 au moyen d'une source de courant. A cet effet, un générateur de courant Ic constant est raccordé à la borne de connexion 21, et donc au curseur 11, par l'intermédiaire d'une résistance R2. Le générateur de courant Ic utilise une tension fixe V- de valeur négative par rapport à celle de la masse 35 afin d'établir le courant sortant du potentiomètre 10 par le curseur 11.

Le dispositif comprend des moyens pour mesurer une différence de tension entre les extrémités 13 et 14. Cette différence de tension forme la tension électrique représentative de la position du curseur 11 entre les extrémités 13 et 14 le long de la résistance 12 du potentiomètre 10.

Avantageusement pour mesurer la différence de tension, le dispositif comprend deux diviseurs de tension 33 et 34. Ces diviseurs permettent de garantir la circulation d'un courant minimum dans les extrémités 13 et 14 du potentiomètre 10. Le premier diviseur 33 est raccordé entre la borne 23 et une tension fixe formée par exemple par une masse électrique 35 du dispositif. Le second diviseur 34 est raccordé entre la borne 24 et une tension fixe également formée par exemple par la masse 35 du dispositif.

Le diviseur 33 est par exemple formé de deux résistances R11 et R21 raccordée en série entre la borne 23 et la masse 35. Le point commun des deux résistances R11 et R21 forme un point intermédiaire 43 du diviseur 33. De même, le diviseur 34 est par exemple formé de deux résistances R12 et R22 raccordée en série entre la borne 14 et la masse 35. Le point commun des deux résistances R12 et R22 forme un point intermédiaire 44 du diviseur 34.

Les deux diviseurs de tension 33 et 34 sont avantageusement identiques. Plus précisément, d'une part, les résistances R11 et R12 ont une même valeur et d'autre part, les résistances R21 et R22 ont une même valeur.

La différence de tension est mesurée entre les deux points intermédiaires 43 et 44, par exemple au moyen d'un voltmètre 50 dont une sortie 51 délivre une tension électrique représentative de la position du curseur 11 le long de la résistance 12.

Il est courant de disposer de sources de tension de valeurs opposées par rapport à une masse dans un équipement électronique. Il est possible d'utiliser ce type d'alimentation pour le dispositif. La tension V+ forme une source de tension positive et on utilise une source de tension opposée V- afin d'établir le courant constant Ic sortant du potentiomètre 10 par le curseur 11. Les deux tensions ont des valeurs opposées V+ et V- par rapport à la masse 35.

La figure 2 représente un exemple de réalisation du dispositif de la figure 1 dans lequel la résistance R1 est choisie à 1kΩ, la résistance R2 à 5kΩ et les résistances R11, R21, R12 et R22 à 2,5kΩ.

Le générateur de courant Ic est formé par un transistor T raccordé entre la résistance R2 et la source de tension V- par l'intermédiaire d'une résistance R4 dont la valeur est choisie à 2,5kΩ. Le transistor T est piloté de façon à conserver une tension constante, ici 5V aux bornes de la résistance R4 et dons un courant constant circulant dans la résistance R4.

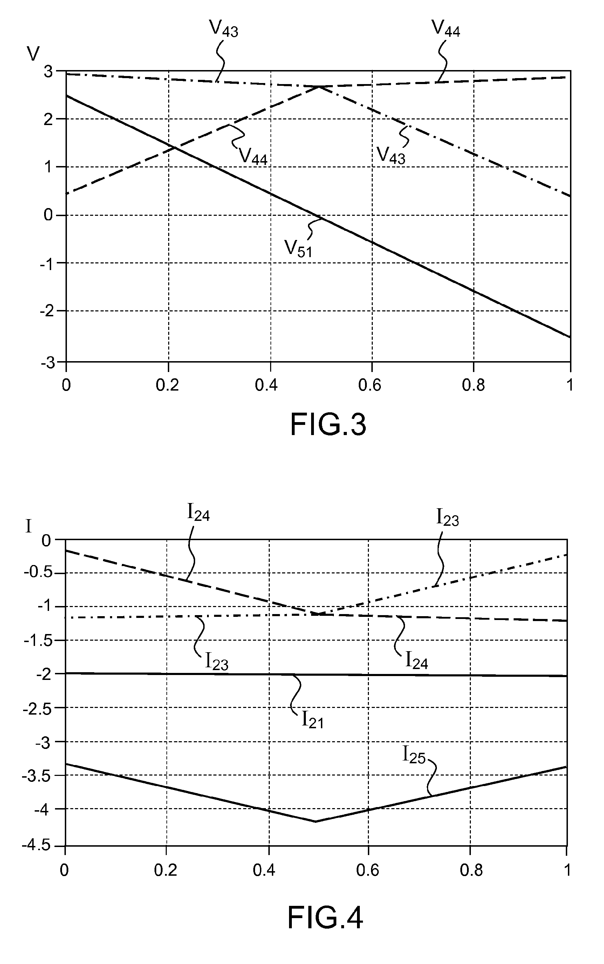

Les figures 3 et 4 représentent l'évolution de tensions et de courants dans le dispositif de la figure 2 en fonction de la position du curseur 11. Plus précisément, dans ces deux figures, l'axe horizontal représente la position du curseur 11 qui évolue par convention entre deux valeurs 0 et 1, « 0 » représentant le curseur 11 au point 14 et « 1 » représentant le curseur 11 au point 13.

Sur la figure 3, l'axe vertical représente la tension en certains points caractéristiques du dispositif. Une courbe en trait mixte représente l'évolution de la tension V₄₃ au point 43, une courbe en trait pointillé représente l'évolution de la tension V₄₄ au point 44 et une courbe en trait continu représente l'évolution de la tension V₅₁ au point 51. La tension V₅₁ est égale à la différence entre les tensions V₄₃ et V₄₄. On constate que l'évolution de la tension V₅₁ est bien linéaire sur l'ensemble du déplacement du curseur 11, ce qui est recherché pour failiter la détermination de la position du curseur 11.

Sur la figure 4, l'axe vertical représente l'intensité du courant circulant en certains points caractéristiques du dispositif. Par convention le sens positif du courant a été défini lorsque le courant rentre dans le potentiomètre 10. Le générateur de courant Ic délivre un courant I₂₁ constant de -2A. Une courbe en trait mixte représente l'évolution du courant I₂₃ dans la borne de connexion 23, une courbe en trait pointillé représente l'évolution du courant I₂₄ dans la borne de connexion 24 et une courbe en trait continu représente l'évolution du courant I₂₅ dans la borne de connexion 25. On constate que quelle que soit la position du curseur 11, on a toujours un courant non nul circulant dans chacune des bornes de connexion 21, 23, 24 et 25.

Les valeurs des résistances ne sont données qu'à titre d'exemple et peuvent être modifiées en fonction des valeurs de l'amplitude de tension souhaitée à l'entrée et à la sortie du voltmètre 50 et en foction des intensités des courants que l'on souhaite faire circuler dans le dispositif.

Avantageusement, le dispositif comprend des moyens de mesure de la tension présente à au moins un des bornes de connexion et des moyens de comparaison de la valeur de la tension mesurée avec une valeur de référence. Une telle surveillance permet de diagnostiquer facilement un défaut du dispositif même lorsque celui-ci est au repos notamment en cas de dégradation et éventuellement de perte de contact au niveau d'une des bornes de connexion 21, 23, 24 ou 25. En effet, toute augmentation de résistance vue depuis la source de courant va se traduire par une varaition de tension sur la borne de connexion surveillée, comme par exemple une augmentation de la tension sur la connexion 21. Une surveillance de cette tension permettra donc de diagnostiquer des défauts même sans déplacer le curseur 11 du potentiomètre 10.

Par exemple, une dégradation de contact sur la borne de connexion 25, entrainant une résistance de contact passant à 1kΩ, se traduit par une diminution significative, 3V dans l'exemple de la figure 2, de la tension présente à la borne de connexion 21.

Une dégradation de contact sur la connexion 21, entrainant une résistance de contact passant à 1kΩ, se traduit par une diminution significative, 2V, de la tension présente à la borne de connexion 21.

Dans ces deux cas, la détection de panne apparaît avant la perte de précision de l'information.

Une dégradation sur les bornes de connexion 23 ou 24 se traduit par une augmentation de la tension présente à la borne de connexion 21. Ce paramètre est moins sensible. Une variation de 10kΩ se traduira par une augmentation de 470mV. Par contre la valeur lue évoluera, ce qui pourra être détectée par une surveillance redondante.

## Revendications

1. Dispositif d'entrée de données comprenant un curseur (11) et des moyens convertissant une position du curseur (11) en une tension électrique, **caractérisé en ce qu'il** comprend en outre :
• un potentiomètre (10) s'étendant entre deux extrémités (13, 14), le potentiomètre (10) possédant un premier (13) et un deuxième (14) points de connexion fixes situés respectivement à chacune des extrémités (13, 14) du potentiomètre (10), un troisième point de connexion fixe (15) situé à une position intermédiaire du potentiomètre (10) entre les deux extrémités (13, 14) et un quatrième point de connexion mobile formant le curseur (11) et pouvant se déplacer entre les deux extrémités (13, 14),
• des moyens (R1) pour alimenter le potentiomètre par le troisième point de connexion (15) au moyen d'une première tension fixe (V+),
• des moyens (R2) pour alimenter le potentiomètre (10) par le curseur (11) au moyen d'une source de courant (Ic),
• des moyens (33, 34, 50) pour mesurer une différence de tension entre le premier et deuxième point de connexion (13, 14), la différence de tension formant la tension électrique représentative de la position du curseur (11).

2. Dispositif selon la revendication 1, **caractérisé en ce que** les moyens pour mesurer une différence de tension entre le premier et deuxième point de connexion comprennent :
• un premier diviseur de tension (33) dont une première extrémité est connectée à l'une (13) des extrémités du potentiomètre en son premier point de connexion, dont une seconde extrémité reçoit une seconde tension fixe (35),
• un second diviseur de tension (34) dont une première extrémité est connectée à l'autre (14) des extrémités du potentiomètre en son premier point de connexion, dont une seconde extrémité reçoit la seconde tension fixe (35),
et **en ce que** la différence de tension est mesurée entre un point intermédiaire (43) du premier diviseur de tension (33) et un point intermédiaire (44) du second diviseur de tension (34).

3. Dispositif selon la revendication 2, **caractérisé en ce que** la première tension fixe (V+) a une valeur positive par rapport à celle de la seconde tension fixe (35) et **en ce que** la source de courant (lc) utilise une troisième tension fixe (V-) de valeur négative par rapport à celle de la seconde tension fixe (35) afin d'établir un courant constant sortant du potentiomètre (10) par le curseur (11).

4. Dispositif selon l'une quelconque des revendications 2 ou 3, **caractérisé en ce que** les deux diviseurs de tension (33, 34) sont identiques.

5. Dispositif selon l'une des revendications précédentes, **caractérisé en ce que** les moyens pour alimenter le potentiomètre (10) par le troisième point de connexion (15) au moyen d'une tension fixe (V+) sont connectés au troisième point de connexion (15) par l'intermédiaire d'une résistance (R1).

6. Dispositif selon l'une des revendications précédentes, **caractérisé en ce que** le troisième point de connexion fixe (15) forme un point milieu du potentiomètre (10) entre les deux extrémités (13, 14).

7. Dispositif selon l'une des revendications précédentes, **caractérisé en ce qu'il** comprend des moyens de mesure de la tension présente à au moins un des bornes de connexion (21, 23, 24, 25) et des moyens de comparaison de la valeur de la tension mesurée avec une valeur de référence.

8. Manche destiné au pilotage d'un aéronef, **caractérisé en ce qu'il** comprend un dispositif d'entrée de données selon l'une des revendications précédentes.

## Patentansprüche

1. Vorrichtung zum Eingeben von Daten, die einen Cursor (11) und Mittel zum Umwandeln einer Position des Cursors (11) in eine elektrische Spannung umfasst, **dadurch gekennzeichnet, dass** sie ferner Folgendes umfasst:
ein Potentiometer (10), das zwischen zwei Enden (13, 14) verläuft, wobei das Potentiometer (10) Folgendes besitzt: einen ersten (13) und einen zweiten (14) festen Anschlusspunkt, die sich jeweils an jedem der Enden (13, 14) des Potentiometers (10) befinden, einen dritten festen Anschlusspunkt (15), der sich an einer Zwischenposition des Potentiometers (10) zwischen den beiden Enden (13, 14) befindet, und einen vierten beweglichen Anschlusspunkt, der den Cursor (11) bildet und sich zwischen den beiden Enden (13, 14) bewegen kann,
Mittel (R1) zum Versorgen des Potentiometers mit einer ersten festen Spannung (V+) über den dritten Anschlusspunkt (15),
Mittel (R2) zum Versorgen des Potentiometers (10) von einer Stromquelle (Ic) über den Cursor (11),
Mittel (33, 34, 50) zum Messen einer Spannungsdifferenz zwischen dem ersten und dem zweiten Anschlusspunkt (13, 14), wobei die Spannungsdifferenz die elektrische Spannung bildet, die für die Position des Cursors (11) repräsentativ ist.

2. Vorrichtung nach Anspruch 1, **dadurch gekennzeichnet, dass** die Mittel zum Messen einer Spannungsdifferenz zwischen dem ersten und dem zweiten Anschlusspunkt Folgendes umfassen:
einen ersten Spannungsteiler (33), von dem ein erstes Ende mit eine (13) der Enden des Potentiometers an seinem ersten Anschlusspunkt verbunden ist, von dem ein zweites Ende eine zweite feste Spannung (35) empfängt,
einen zweiten Spannungsteiler (34), von dem ein erstes Ende mit dem anderen (14) der Enden des Potentiometers am ersten Anschlusspunkt verbunden ist, von dem ein zweites Ende die zweite feste Spannung (35) empfängt,
und dadurch, dass die Spannungsdifferenz zwischen einem Zwischenpunkt (43) des ersten Spannungsteilers (33) und einem Zwischenpunkt (44) des zweiten Spannungsteilers (34) gemessen wird.

3. Vorrichtung nach Anspruch 2, **dadurch gekennzeichnet, dass** die erste feste Spannung (V+) einen positiven Wert mit Bezug auf den der zweiten festen Spannung (35) hat, und dadurch, dass die Stromquelle (Ic) eine dritte feste Spannung (V-) mit einem negativen Wert mit Bezug auf den der zweiten festen Spannung (35) nutzt, um einen Konstantstrom zu erzeugen, der vom Potentiometer (10) durch den Cursor (11) geht.

4. Vorrichtung nach Anspruch 2 oder 3, **dadurch gekennzeichnet, dass** die beiden Spannungsteiler (33, 34) identisch sind.

5. Vorrichtung nach einem der vorherigen Ansprüche, **dadurch gekennzeichnet, dass** die Mittel zum Versorgen des Potentiometers (10) durch den dritten Anschlusspunkt (15) mittels einer festen Spannung (V+) mit dem dritten Anschlusspunkt (15) über einen Widerstand (R1) verbunden sind.

6. Vorrichtung nach einem der vorherigen Ansprüche, **dadurch gekennzeichnet, dass** der dritte feste Anschlusspunkt (15) einen mittleren Punkt des Potentiometers (10) zwischen den beiden Enden (13, 14) bildet.

7. Vorrichtung nach einem der vorherigen Ansprüche, **dadurch gekennzeichnet, dass** sie Mittel zum Messen der an wenigstens einem der Anschlusspunkte (21, 23, 24, 25) anliegenden Spannung und Mittel zum Vergleichen des Wertes der gemessenen Spannung mit einem Referenzwert umfasst.

8. Knüppel zum Steuern eines Luftfahrzeugs, **dadurch gekennzeichnet, dass** er eine Vorrichtung zum Eingeben von Daten nach einem der vorherigen Ansprüche umfasst.

## Claims

1. Data input device comprising a slider (11) and means converting a position of the slider (11) into an electrical voltage, **characterized in that** it furthermore comprises:
• a potentiometer (10) extending between two ends (13, 14), the potentiometer (10) having a first (13) and a second (14) fixed connection point which are respectively situated at each of the ends (13, 14) of the potentiometer (10), a third fixed connection point (15) situated at an intermediate position on the potentiometer (10) between the two ends (13, 14) and a fourth, mobile connection point forming the slider (11) and being able to move between the two ends (13, 14),
• means (R1) for supplying a first fixed voltage (V+) to the potentiometer via the third connection point (15),
• means (R2) for supplying a current source (Ic) to the potentiometer (10) via the slider (11),
• means (33, 34, 50) for measuring a voltage difference between the first and second connection points (13, 14), the voltage difference forming the electrical voltage that represents the position of the slider (11).

2. Device according to Claim 1, **characterized in that** the means for measuring a voltage difference between the first and second connection points comprise:
• a first voltage divider (33), a first end of which is connected to one (13) of the ends of the potentiometer at the first connection point thereof, and a second end of which receives a second fixed voltage (35),
• a second voltage divider (34), a first end of which is connected to the other (14) of the ends of the potentiometer at the first connection point thereof, and a second end of which receives the second fixed voltage (35),
and **in that** the voltage difference is measured between an intermediate point (43) on the first voltage divider (33) and an intermediate point (44) on the second voltage divider (34).

3. Device according to Claim 2, **characterized in that** the first fixed voltage (V+) has a positive value with respect to that of the second fixed voltage (35) and **in that** the current source (Ic) uses a third fixed voltage (V-) having a negative value in relation to that of the second fixed voltage (35) in order to set up a constant current leaving the potentiometer (10) via the slider (11).

4. Device according to either of Claims 2 and 3, **characterized in that** the two voltage dividers (33, 34) are identical.

5. Device according to one of the preceding claims, **characterized in that** the means for supplying a fixed voltage (V+) to the potentiometer (10) via the third connection point (15) are connected to the third connection point (15) by means of a resistor (R1).

6. Device according to one of the preceding claims, **characterized in that** the third fixed connection point (15) forms a middle point on the potentiometer (10) between the two ends (13, 14).

7. Device according to one of the preceding claims, **characterized in that** it comprises means for measuring the voltage present at at least one of the connection terminals (21, 23, 24, 25) and means for comparing the measured value of the voltage with a reference value.

8. Joystick intended for piloting an aircraft, **characterized in that** it comprises a data input device according to one of the preceding claims.
